# NEUE EUROPÄISCHE PATENTSCHRIFT

(11) **EP 1 982 824 B2**
(45) Veröffentlichungstag und Bekanntmachung des Hinweises auf die Entscheidung über den Einspruch: **28.06.2023**
(45) Hinweis auf die Patenterteilung: 27.01.2016
(21) Anmeldenummer: 08011621.3
(22) Anmeldetag: 08.03.2007
(51) Int. Cl.: G03F 7/00, G03F 7/20, B29C 64/129, B33Y 10/00

(54) **Vorrichtung und Verfahren zur Herstellung eines dreidimensionalen Objekts mittels Maskenbelichtung**
Device and method for creating a three dimensional object using mask illumination
Procédé et dispositif destinés à la fabrication d'un objet tridimensionnel à l'aide d'un éclairage par masques

(30) Priorität: 28.04.2006 DE 102006019963; 28.04.2006 US 796159 P
(43) Veröffentlichungstag der Anmeldung: 22.10.2008
(62) Teilanmeldung aus: 07004774.1
(73) Patentinhaber: Envisiontec GmbH, 45968 Gladbeck (DE)
(72) Erfinder: John, Hendrik, 46569 Hünxe (DE); Schillen, Volker, 40629 Düsseldorf (DE); El-Siblani, Ali, Dearborn Heights, MI 48127 (US)
(74) Vertreter: Prüfer & Partner mbB Patentanwälte · Rechtsanwälte

(56) Entgegenhaltungen:
- WO-A-01/00390
- WO-A-96/00422
- WO-A-2005/110722
- US-B1- 6 391 245
- US-B1- 6 500 378

## Beschreibung

Die Erfindung betrifft eine Vorrichtung zur Herstellung eines dreidimensionalen Objektes durch Verfestigen eines unter Einwirkung von elektromagnetischer Strahlung verfestigbaren Materials, insbesondere eines Photopolymers, mittels Energieeintrag über eine bildgebende Einheit, die eine bestimmte Anzahl diskreter bildgebender Elemente (Pixel) aufweist. Insbesondere betrifft diese Erfindung Verfahren, bei denen die Verfestigung auf einer Belichtung mittels einer gerasterten Maske beruht, wobei die kleinste physikalische Auflösung in der Maske durch die Größe eines Pixels gegeben ist und die bildgebende Einheit auf der Spacial Light Modulator (SLM) Technologie beruht.

### Stand der Technik

Für den Aufbau dreidimensionaler Objekte aus "lichthärtenden" Photopolymeren werden in der Literatur unterschiedlichste Verfahren angegeben, siehe hierzu "Automated Fabrication - Improving Productivity in Manufacturing" von Marshall Burns, 1993 (ISBN 0-13-119462-3).

Bekannte Möglichkeiten sind u.a. die Belichtung durch
a) Multimedia Projektor
b) LC-Display (reflexiv, transmissiv)
c) LED-, bzw. Laser-Dioden-Zeile (die orthogonal zur Zeile über eine Fläche bewegt wird)
d) Lichtventil-Technologie (MEMS)

Diese Methoden werden in folgenden Patenten beschrieben:
US-Patent US005247180A "Stereolithographic Apparatus and Method of use" von Texas Instruments Inc., Sept. 1993.
US-Patent US005980813A "Rapid Prototyping using multiple materials" von SRI International, Nov. 1999;
Gebrauchsmusterschrift DE G 93 19 405.6 "Vorrichtung zur Herstellung eines dreidimensionalen Objekts (Modells) nach dem Prinzip der Photoverfestigung" vom Forschungszentrum Informatik an der Universität Karlsruhe, Dez. 1993;
eine Anwendung für die Erzeugung mikrotechnischer, dreidimensionaler Bauteile nach einem ähnlichen Verfahren wird in der Gebrauchsmusterschrift DE 299 11 122 U1 "Vorrichtung zum Herstellen eines dreidimensionalen Objektes", DeltaMed u.a., Juni 1999, beschrieben.
EP 1250997A (= US2002155189A) "Vorrichtung zum Herstellen eines dreidimensionalen Objektes" der Envision Technologies GmbH, April 2002.
Deutsches Patent DE69909136T "Rapid-Prototyping-Vorrichtung und Rapid-Prototyping-Methode", Juli 2003 (entsprechend Europäisches Patent EP 1156922 "Rapid Prototyping Apparatus and Method of Rapid Prototyping", August 2003) der DICON AS Lystrup, Dänemark.
WO 01/00390 A von HAP, Sitec Industrietechnologie und DELTAMED Medizinprodukte GmbH.
WO 2005/110722 A der Envisiontec GmbH.

Bei Laser-basierten Systemen zur Photopolymerisation wird die Lichtleistung im Belichtungspunkt durch die Energieeinstellung des Laserstrahls vorgenommen, wodurch die Durchhärtetiefe des verfestigbaren Materials wie des Photopolymers in diesem Punkt gesteuert werden kann.

Um selektiv auszuhärten, wird der Laserstrahl über die entsprechend auszuhärtende Querschnittsfläche gescannt.
Die Konturen der auszuhärtenden Querschnittsfläche können vom Laserstrahl als Kurve abgefahren werden.

Bei Systemen zur Photopolymerisation basierend auf Maskenprojektion mittels Projektionssystemen, speziell mit der SLM-Technologie, wird üblicherweise eine Querschnittesfläche auf einmal belichtet. Die weißen Bereiche des projezierten Bildes härten das verfestigbare Material (normalerweise ein Photopolymer) aus, die schwarzen Bereiche nicht. Die Konturen der auzuhärtenden Querschnittsfläche können nur gerastert dargestellt werden; die Auflösung ist abhängig von der Anzahl der Bildpunkte bzw. der Pixel und der Größe des projizierten Bildes.

Das Dokument US 6 500 378 B1 offenbart eine Vorrichtung gemäß dem Oberbegriff des Anspruchs 1 und ein Verfahren gemäß dem Oberbegriff des Anspruchs 11. Dabei zeigt diese US 6 500 378 B1 eine Grauwert-Modulierung von Pixeln in einem Maskenprojektionssystem, um eine gewünschte ausgehärtete Flächengröße zu erreichen, oder um dünnere Schichten oder Flächen bestimmter Schichten zu bilden.

Bei der oben genannten WO 01/00390 A wird die Intensität von Strahlen durch Steuerung der Durchlässigkeit der Maske gesteuert, wobei die Steuerung der Intensität über die Ansteuerung von Graustufen eines Transmissions-LCD erfolgen kann. Eine Belegung mit unterschiedlichen Lichtintensitäten erfolgt jedoch bezogen auf eine jeweilige Schicht nur danach, ob verfestigte Bereiche darunterliegen oder nicht. Von einer Einstellung und/oder Steuerung eines Energieeintrags in einer Voxel-Matrix gemäß der vorliegenden Erfindung ist in WO 01/00390 A keine Rede. In der vorliegenden Erfindung geht es um Auflösung und Feinabstimmung in einer Voxel-Matrix; während eine Grauwertgradation je nachdem, ob eine darunterliegende gehärtete Schicht abwesend ist oder zum Verbinden vorhanden ist, bei der vorliegenden Erfindung entbehrlich ist.
Bei der WO 2005/110722 A wird zur Verbesserung der Auflösung entlang der Außen- und Innenkonturen der Querschnittsflächen des zu generierenden Objektes im Subpixelbereich eine Mehrfachbelichtung vorgenommen, die aus einer Abfolge einer Mehrzahl von im Subpixelbereich versetzten Bildern in der Bild-/Bauebene besteht, wobei für jedes versetzte Bild eine separate Maske/Bitmap erzeugt wird. Eine Graustufeneinstellung wird für durch den Subpixelversatz erhaltene Kontur-Pixel in Betracht gezogen. Auch in der WO 2005/110722 A ist keine Rede von einer Einstellung und/oder Steuerung eines Energieeintrags in einer Voxel-Matrix gemäß der vorliegenden Erfindung.
Weder in der WO 01/00390 A noch in der WO 2005/110722 wird gezeigt, wie die Auflösung und die Feineinstellung verbessert werden können oder wie native Inhomogenitäten der Lichtquelle besser ausgeglichen werden können.

### Aufgabe der Erfindung

Aufgabe der Erfindung ist es, Vorrichtung und Verfahren zur Herstellung eines dreidimensionalen Objektes durch Verfestigen eines unter Einwirkung von elektromagnetischer Strahlung verfestigbaren Materials mittels Energieeintrag über eine bildgebende Einheit, die eine bestimmte Anzahl diskreter bildgebender Elemente (Pixel) aufweist, so zu verbessern, dass eine höhere Genauigkeit, höhere Auflösung und Feineinstellung und/oder eine höhere Homogenität des Systems erreicht wird.

### Lösung der Aufgabe

Die Erfindung stellt eine Vorrichtung gemäß Anspruch 1 dar.

Die Erfindung stellt ferner ein Verfahren nach Anspruch 10 bereit. Bevorzugte Ausführungsformen sind in den Unteransprüchen festgelegt.

Es hat sich als besonders vorteilhaft erwiesen, den Energieeintrag über einen bestimmten Grauwert und/oder Farbwert in einer Voxel-Matrix selektiv einzustellen und/oder zu steuern. Weiter bevorzugt wird eine gerasterte Maske (Bitmap) ohne Subpixelversatz verwendet.

Unter Voxel-Matrix ist erfindungsgemäß eine gerasterte Anordnung von ausgehärteten Voxeln (Volumen-Pixeln) zu verstehen, wobei ein Voxel ein Bildpunkt einer Pixel-Matrix abbildet und die Durchärtetiefe je Voxel abhängig ist von der je Bildpunkt eingekoppelten Energie.

Es wird die Fähigkeit zur Einstellung und/oder Steuerung eines bestimmten Grauwerts und/oder Farbwerts vorteilhaft spezifisch und individuell pro Pixel bereitgestellt.

In einer nicht beanspruchten Ausführungsform kann die Ausgestaltung der bildgebenden Einheit vorteilhaft derart sein, daß die Zuordnung bzw. Einstufung von Pixeln in die mehr als zwei Energiestufen spezifisch und individuell pro Pixel bereitgestellt werden.
Die mehr als zwei Energiestufen schließen bevorzugt ein:
a1) AN- und AUS-Zustände durch im wesentlichen vollständigen Energiedurchlass (weiß) bzw. im wesentlichen vollständiger Energieblockage ohne Energiedurchlaß (schwarz) bei transmissiven Systemen (insbesondere mit Light-Valves) oder
a2) AN- und AUS-Zustände durch im wesentlichen vollständige Energie-Reflexion in die optische Achse (weiß im Projektionsbild) bzw. im wesentlichen vollständige Reflexion aus der optischen Achse heraus in einen optischen Absorber (schwarz im Projektionsbild) bei reflexiven Systemen (insbesondere mit Digital Micromirror Device [DMD] oder Liquid Crystal on Silicon [LCoS] zur digitalen Lichtprozessierung [DLP]), und zusätzlich
b1) eine bestimmte, gewünschte Anzahl von Graustufen oder
b2) eine bestimmte, gewünschte Anzahl von Farbwerten. Die Farbwerte können einen Farbton und/öder eine Farbdichte bzw. -intensität repräsentieren.

Erfindungsgemäß kann die Anpassung bzw. Einstellung über Farbwerte im Vergleich zu Grauwerten besonders vorteilhaft sein, weil dann eine signifikant bessere Feineinstellung, spezifisch bezogen auf das jeweils verwendete Photopolymer, möglich ist.

In einer bevorzugten Weiterbildung kann die bildgebende Einheit der Vorrichtung in einer Projektionseinheit eingeschlossen sein. Die bildgebender Einheit ist üblicherweise so aufgebaut, daß die Anzahl der Pixel konstant ist und in der Ebene räumlich zueinander fest angeordnet sind.

In einer bevorzugten Weiterbildung kann die bildgebende Einheit die Vorrichtung vom Typ eines emittierenden Punkts, einer emittierende Zeile oder einer emittierenden Matrix sein. Eine Auflösungsverbesserung wird insbesondere dann erreicht, wenn die bildgebende Einheit ein Spatial Light Modulator (SLM) oder Light-Valves in MEMS-Technologie oder LED's einschließt.

In einer Weiterbildung stellt die vorliegende Erfindung ferner ein Verfahren bereit zur Herstellung eines dreidimensionalen Objektes durch Verfestigen eines, unter Einwirkung von elektromagnetischer Strahlung verfestigbaren Materials mittels Energieeintrag über eine bildgebende Einheit, die eine bestimmte Anzahl diskreter bildgebender Elemente (Pixel) aufweist, wobei die Lichtleistung zur Verfestigung des Materials bei mindestens einem Teil der Pixel über einen definierten Grauwert und/oder Farbwert gesteuert wird.
Durch diese Maßnahme kann vorteilhaft die Durchdringungstiefe der elektromagnetischen Strahlung zur Verfestigung des Materials wesentlich feiner und variabel und pixelgenau eingestellt werden, indem ein Grauwert und/oder eine Farbwert in einer Voxel-Matrix selektiv gesteuert wird, und wobei vorzugsweise eine gerasterten Maske (Bitmap) ohne Subpixelversatz verwendet wird.

Informationen zu Grauwert und/oder Farbwert können in dem gerasterten Bild (Bitmap) pro Bildpunkt (Pixel) gespeichert sein.

In einer bevorzugten Ausführungsform des erfindungsgemäßen Verfahrens wird zur Verfestigung des Materials die Belichtungsmaske bzw. das Bild mittels einer Projektionseinheit in die Bauebene projiziert.

In einer besonderen Ausführungsform der Vorrichtung und des Verfahrens gemäß der Erfindung wird ermittelt, welche Pixel von der Grafik wie stark überschnitten werden. Je nach Ergebnis dieser Ermittlung wird pixel-spezifisch ein entsprechend gewichteter Grauwert oder ein bestimmter Farbwert zugeordnet. Durch diese Maßnahme kann die Auflösung bei sehr feinen Strukturen signifikant verbessert werden. Alternativ oder zusätzlich wird durch diese Maßnahmen bei der Rasterung einer Kontur-Linie ein Antialiasing berücksichtigt, wodurch der so genannte Treppeneffekt im Kanten-/Kontur-Bereich, der bei der Rasterung einer Vektorgrafik - hier der zu belichtenden Querschnittsstruktur - entsteht, beseitigt bzw. reduziert wird.

Eine Mehrfachbelichtung und/oder ein Subpixelversatz ist dabei erfindungsgemäß nicht erwünscht.

Gemäß der Erfindung werden in einem Querschnittsbild, das zur Verfestigung erzeugt wurde, verschiedene Bereiche unterschiedlicher Flächenausdehnung identifiziert. Die Pixel der jeweils identifizierten Bereiche werden mit einheitlichen Grauwerten und/oder Farbwerten belegt, so daß sich Grauwert und/oder Farbwert über die jeweiligen Bereiche ausdehnen. So werden zum Beispiel größere Flächenstrukturen entsprechend ihrer Ausdehnung abgedunkelt, während kleinere Flächenstrukturen heller bestrahlt werden. Dadurch wird eine gleichmäßige Durchhärtetiefe über das gesamte Querschnittsbild und somit über die gesamt zu belichtende Fläche erhalten.

In einer bevorzugten Ausführungsform der Vorrichtung und des Verfahrens gemäß der Erfindung erfolgt eine erhöhte Aushärtung selektierter Flächenbereiche durch Ein- oder MehrfachBelichtung einer Voxel-Matrix, indem eine entsprechende Grauwertbelegung innerhalb der Voxel-Matrix vorgenommen wird, wobei in den selektierten Bereichen die so erreichte Durhärtetiefe in Z-Richtung der Voxel-Matrix erhöht ist. Die Durchhärtetiefe des selektierten Bereichs, der nicht oder mit einem geringeren Grauwert bzw. Farbwert belegt ist, ist vorzugsweise um ein Vielfaches, d.h. um mindestens das Dreifache, vorzugsweise mindestens das Vierfache und weiter bevorzugt mindestens das Fünffache erhöht ist gegenüber dem übrigen Bereich.

In einer bevorzugten Ausführungsform der Vorrichtung und des Verfahrens gemäß der Erfindung werden Informationen bezüglich Grauwert und/oder Farbwert pro Bildpunkt (Pixel) online für jedes gerasterte Bild (Bitmap) aktuell berechnet.

### Beschreibung der bevorzugten Ausführungsformen und der Vorteile der Erfindung

Vorrichtung und Verfahren gemäß der Erfindung erlauben es, die Homogenität der Lichtleistungsverteilung zu verbessern. Speziell kann durch eine Lichtleistungssteuerung mittels Graustufen und/oder Farbwerten im Makrobereich oder spezifisch auf Pixel-Niveau im Mikrobereich die Abbildungsleistung durch Bitmapping für eine Voxel-Matrix verbessert werden. Abbildungsverluste, die durch eine reine AN/AUS (WEISS/SCHWARZ) - Rasterung verursacht werden, können reduziert werden. Das Auflösungsvermögen in der Bauebene wird verbessert, ohne die Auflösung der bildgebenden Einheit erhöhen zu müssen. Somit wird insgesamt die Qualität des Bauteils in Bezug auf Oberflächenglätte, Detailtreue und Toleranzen verbessert.

Insbesondere bei Projektionssystemen mit SLM-Technologie kann die Lichtleistungsverteilung über die Bildfläche deutlich verbessert werden (gegenüber einer herkömmlich unter Umständen inhomogenen Verteilung von absolut bis zu 50%). Mithilfe einer Weiterbildung wird daher die Abhängigkeit bzw. der Einfluß im Vergleich zum Stand der Technik verringert in Bezug auf a) die verwendete Lichtquelle, b) das optische System zur Einkopplung der Lichtenergie (speziell auf den SLM) und c) die Vignetierung der Projektionsoptik.
Selbst wenn sich die Eigenschaften der Lichtquelle über die Zeit verändern, kann dies korrigiert werden, so daß variable Fehler und sich verändernde Homogenitätsverteilungen kompensiert werden können. Mit der Weiterbildung können falls gewünscht sogar konstante Fehler, die durch das optische System zur Einkopplung der Lichtenergie auf den SLM und die Projektionsoptik hervorgerufen werden können, durch Ausgleich von Homogenitätsabweichungen vermieden werden.

Mit dem erfindungsgemäßen Konzept kann das Problem angegangen werden, daß die Lichtintensität in Abhängigkeit von der Größe der belichteten Flächenstruktur (höhere Lichtintensität bei größeren, zusammenhängenden Flächen, geringere Lichtintensität bei kleinen, filigranen Flächenstrukturen) variiert, weshalb ohne die erfindungsgemäße Maßnahme die Inhomogenität der Lichtleistungsverteilung im projizierten Bild zu entsprechenden Abweichungen in der Durchhärtetiefe des Photopolymers und somit zu Fehlern / Abweichungen, Ungenauigkeiten im Bauteil beim Einsatz von Maskenprojektion mittels SLM-Technologie führen kann.

Mittels der Graustufen-Steuerung und/oder der Farbwert-Steuerung kann die Lichtleistungsverteilung sowohl über das Gesamtbild (Graumasken-Kompensation) . Makro-Anpassung - als auch auf Pixel-Niveau - Mikro-Anpassung - angepasst werden, ohne den nativen Zustand der Lichtquelle und / oder der abbildenden Opitk zu verändern. Die Mikroanpassung erfolgt am besten selektiv, d.h. abhängig von der abzubildenden Querschnittsstruktur und während der Generierung der Bitmap der Querschnittsfläche für die jeweils aktuell gebildete Voxel-Matrix.

Ferner kann mit der Maßnahme, mindestens einem Teil der Pixel mehr als zwei Energiestufen zuzuordnen, insbesondere zusätzlich zu den normalen AN- und AUS-Zuständen (weiß/schwarz) weitere Energiestufen über eine bestimmte Zahl von Graustufen, bevorzugt über eine bestimmte Zahl von Farbwerten bereitzustellen, eine wesentlich bessere Feinabstimmmung des Energieeintrags erzielt werden.

Betriebsbedingungen können ebenso, insbesondere die Durchhärtetiefe über die gesamte abzubildende Querschnittsfläche weitestgehend konstant gehalten oder gezielt selektiv zwecks Über- oder Unterbelichtung selektierter Bereiche manipuliert werden, was zu einer Verbesserung der Bauteil-Qualität führt. Eine bessere Auflösung und eine bessere Feinabstimmung wird insbesondere dann erzielt, wenn als Parameter für Über- oder Unterbelichtung eingeschlossen werden:
- Grad der Überlappung des gerasterten Pixels durch die Vektorgrafik, und/oder
- Größe der Fläche des Querschnittsbildes.

Auch können Abweichungen kompensiert werden, die z.B. durch Alterung der Lichtquelle oder sonstige optische Fehler herrühren.

Die Graustufen-Steuerung und/oder die Farbwert-Steuerung kann am zweckmäßigsten vollständig software-technisch durchgeführt werden. Als geeignete Komponenten zu diesem Zweck können eine Computereinheit wie eine CPU, ein IC und/oder eine Softwareimplementierung mit jeweils entsprechender Funktion dienen. Das System ist somit sehr flexibel und für alle auf. SML-Technologie basierende Maskenprojektionssysteme einsetzbar.

Ein weiterer großer Vorteil ist, dass die selektive, pixelgenaue Lichtleistungsanpassung unabhängig von der Belichtungszeit durch die Graustufen- und/oder Farbstufen-Steuerung erfolgen kann. Die Belichtungszeit kann vorteilhaft für alle Bitmaps konstant bleiben.

Die Erfindung wird anhand von weiteren Ausführungsbeispielen unter Bezugnahme auf die beigefügten Figuren näher beschrieben; sie ist jedoch keineswegs auf die beschriebenen Ausführungsformen und -beispiele und Zeichnungen beschränkt, sondern kann beliebige Variationen und Modifikationen im Rahmen der Ansprüche einschließen.

In den veranschaulichenden Figuren wird gezeigt:
Fig. 1 zeigt schematisch ein Konzept zur Grauwert oder Farbwertanpassung auf makroskopischem Niveau gemäß einer Ausführungsform unter Verwendung einfacher Kacheln mittels Kompensationsmaske;
Fig. 2 zeigt schematisch ein anderes Konzept zur Grauwert oder Farbwertanpassung auf makroskopischem Niveau gemäß einer anderen Ausführungsform, wobei eine Interpolation zwischen einzelnen Meßpunkte verwendet wird zum Generieren einer Kompensationsmaske;
Fig. 3 zeigt schematisch eine Geometrie eines Modells für ein dreidimensionales Objekt mit unterschiedlich großen Löchern und Zylindern, als Grundlage zum Erzeugen einer Bitmap;
Fig. 4 zeigt ein Vergleichsbeispiel des Erzeugens einer Bitmap ohne pixelgenaue Grauwert- oder Farbwertanpassung;
Fig. 5 zeigt ein Beispiel des Erzeugens einer Bitmap pixelgenaue Grauwert- oder Farbwertanpassung oder -steuerung auf mikroskopischem Niveau, wobei die Anpassung bzw. die Steuerung vom Ausmaß einer Überlappung von gerasterten Pixeln durch die Vektorgraphik abhängt;
Fig. 6 zeigt in der linken Präsentation ein Vektor-basiertes Ausgangsbit einer abzubildenden Qüerschnittstruktur mit überlagertem Raster (Pixel sind hier als Quadrate wiedergegeben); in der rechten Präsentation ist die erzeugte Bitmap auf der Basis einer gerasterten Graphik gezeigt - hier mit Kantenglättung, die durch Grauwert- oder Farbwertanpassung auf mikroskopischem Niveau erhalten wurde in Abhängigkeit davon, ob und in welchem Ausmaß Pixel durch die Graphik überdeckt sind, derart, daß sie mit einem entsprechend gewichteten Grauwert belegt sind;
Fig. 7 zeigt schematisch eine grundsätzliche Vorrichtung, die zur Generierung eines dreidimensionalen Objekts gemäß der vorliegenden Erfindung verwendet werden kann, wobei das dreidimensionale Objekt in dieser Ausführungsform in Form von Schichten aufgebaut wird; und
Fig. 8 zeigt schematisch eine grundsätzliche Vorrichtung, die zur Generierung eines dreidimensionalen Objekts werden kann, wobei das dreidimensionale Objekt in dieser Ausführungsform unabhängig von Schichten aufgebaut wird.

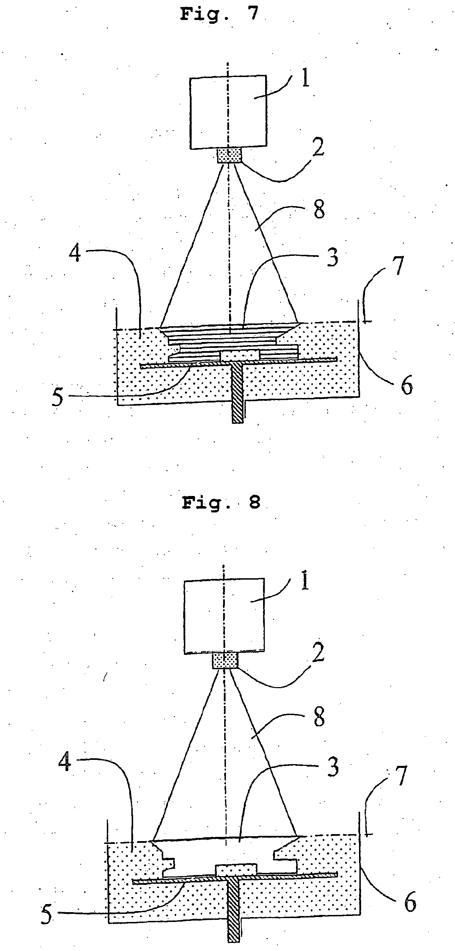

**Fig. 7** zeigt schematisch eine grundsätzliche Vorrichtung zur Generierung eines dreidimensionalen Objekts 3 durch Aushärtung eines photohärtenden Materials 4 mittels Maskenprojektion 8, wobei sich die Projektionseinheit 1 mit einer abbildenden Optik 2 oberhalb des Beckens 6, gefüllt mit photohärtendem Material 4, befindet und das Objekt 3 auf einer Trägerplatte 5 aushärtet, die innerhalb des Beckens 6 in vertikaler Richtung bewegt werden kann. In der dargestellten Arbeitsweise erfolgt der Aufbau des dreidimensionalen Objekts 3 schichtweise. Alternativ kann der Aufbau jedoch auch schichtenunabhängig erfolgen. Weitere Ausgestaltungsmöglichkeiten sind möglich. Zum Beispiel kann der Aushärtungsprozess kontinuierlich ohne Schichten; diskontinuierlich (mit gleichen, verschiedenen oder variablen Schichtdicken); teilweise kontinuierlich und teilweise diskontinuierlich (diskontinuierlich mit gleichen, verschiedenen oder variablen Schichtdicken); oder in einer Kombination verschiedener Möglichkeiten erfolgen.

Als Beispiel zeigt **Fig. 8** schematisch eine veranschaulichende Ausführungsform als Alternative zu der in Fig. 7 gezeigten Vorrichtung, wobei die gleichen Bezugszeichen sich entsprechende Bauteile bezeichnen, wobei jedoch das dreidimensionale Objekt 3 unabhängig von irgendwelchen Schichten gebaut wird.

Die Vorrichtung und das Verfahren gemäß der vorliegenden Erfindung ist besonders geeignet zum Erstellen eines dreidimensionalen Objekts unabhängig von Schichten.

Bei einem auf Photoploymerisation basierenden Verfahren wird die zum Härten notwendige Lichtstrahlung in die Bearbeitungsebene projiziert. Die Belichtung wird mit Hilfe eines Multimedia-Projektors ausgeführt. Das Bild setzt sich dabei aus einzelnen Bildpunkten (Pixeln) zu einer sogenannten Bitmap zusammen. Die Bitmap-Maske wird durch einen Spatial Light Modulator gebildet, wobei die Pixel in der Ebene räumlich zueinander fest angeordnet sind. Eine derzeit gängige, beispielhafte Auflösung für solche Halbleiterelemente liegt bei SXGA+ 1400 x 1050 Bildpunkten.

### Graustufen-Steuerung / Makro-Anpassung

Bei der Makro-Anpassung geht es darum, die nativen Abweichungen in der Lichtleistungsverteilung über die gesamte Bildfläche, hervorgerufen durch das optische System bzw. dessen Fehler mittels einer Grau- oder Farb-Maskenkompensation auszugleichen.

Hierzu werden multiple Messwerte gleichmäßig verteilt über die gesamte Bildfläche aufgenommen und eine Kompensationsmaske aus Grauwerten oder Farbwerten errechnet, die über jede einzelne projizierte Bitmap-Maske gelegt bzw. überlagert wird.

Durch dieses Verfahren wird die Homogenität mindestens um den Faktor zwei verbessert.

Die Messungen können entweder manuell erfasst oder über eine Sensor-Matrix ermittelt werden.

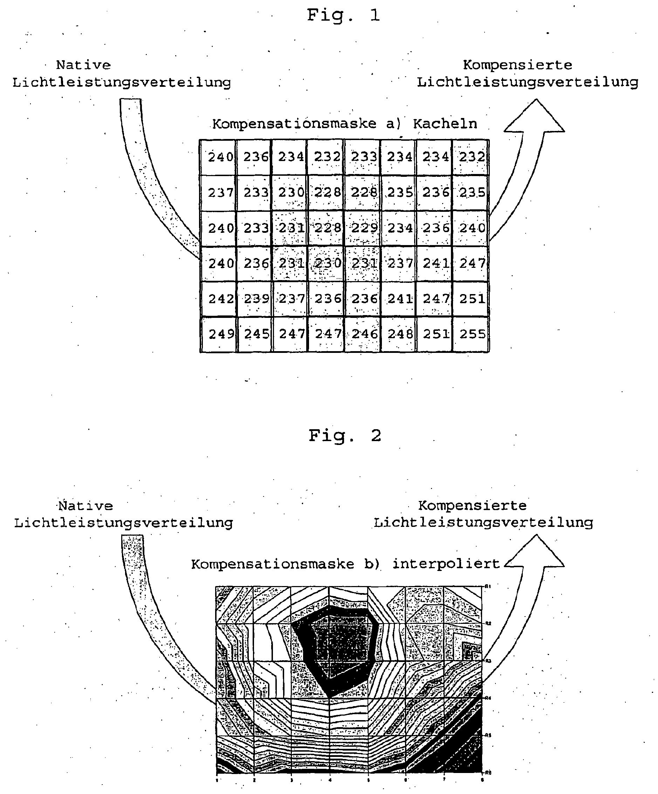

Als eine Ausführungsform der Kompensationsmaske kann eine einfache Kachelung bei der Kompensationsmaske eingesetzt werden **(****Fig. 1****),** als andere Ausführungsform können die Kompensations-Grauwerte oder Farbwerte zwischen den einzelnen Messpunkten interpoliert werden **(****Fig. 2****)** und so eine Kompensationsmaske mit weichen/kontinuierlichen Übergängen zwischen den einzelnen Messpunkten erzeugt werden.

### Graustufen-Steuerung / Mikro-Anpassung

Bei der Mikro-Anpassung geht es darum eine möglichst originalgetreue Abbildung der zu projizierenden Querschnittsfläche mit höchster Genauigkeit zu erhalten und außerdem die Belichtungs- und Aushärte-Parameter über die zu belichtende Struktur entweder konstant zu halten oder gezielt Pixelgenau durch Grauwert- oder Farbwert-gesteuerte Über- oder Unterbelichtung zu beeinflussen.

### Anwendungsbeispiele:

### Pixelgenaue Anpassung der Grauwerte bei zu belichtenden Strukturen kleiner 3x3 Pixel in der Abbildungsebene

Hier kann es passieren, dass bei einer Strukturgröße von 1,5 x 1,5 Pixeln durch eine ungünstige Pixel-/Bitmap-Verteilung bzw. Rasterung bei einer reinen Schwarz/Weiß Umsetzung entweder nur ein Pixel oder gleich 3 x 3 Pixel Weiß geschaltet werden. Bei noch kleineren Strukturen in 1 Pixel-Größe kann es sogar zu vollständigem Verlust der abzubildenden Struktur in der Bitmap kommen.

Um dies zu verhindern, wird jedem Pixel abhängig vom Grad der Überlappung durch die abzubildende Struktur ein entsprechender Grauwert zugeordnet. Dies kommt insbesondere im Konturbereich der Struktur zum tragen.

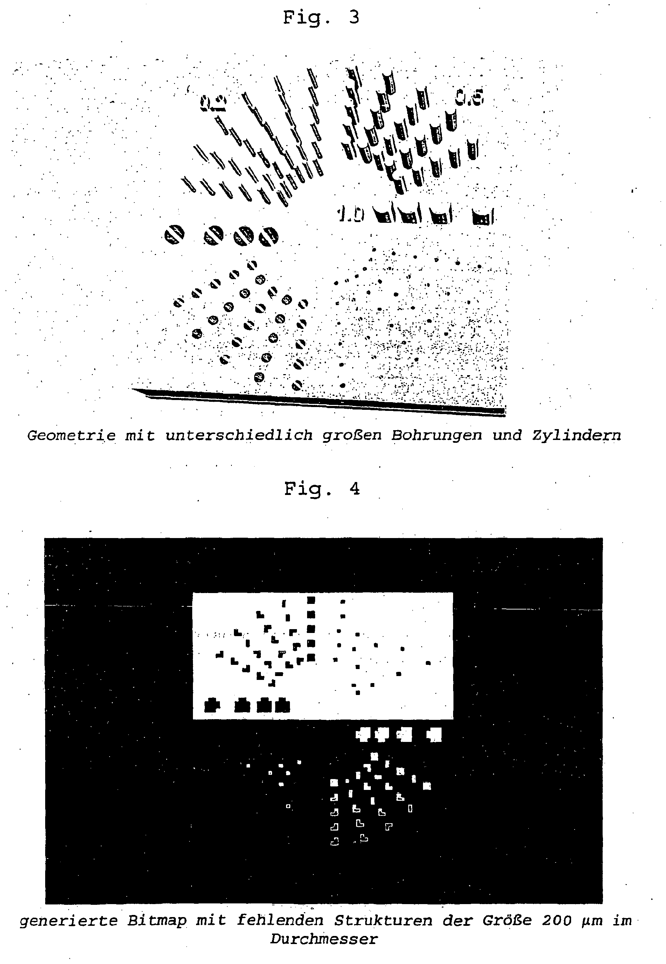

Das Prinzip wird hier anhand einer Struktur dargestellt, die sowohl kleine Löcher als auch kleine Zylinder in unterschiedlicher Größe (Durchmesser 200, 500 und 1000 µm) aufweist **(****Fig. 3****),** aus deren Querschnittsflächen jeweils eine Bitmap-Maske generiert wird.
Aus der Auflösung der Rasterung, hier *1280 x 1024 Pixel* und der Größe des Baüfeldes, hier 317.5 *x 254 mm,* ergibt sich eine Pixelgröße von 248 µm.

Es ist zu beachten, dass die kleinste Struktur hier kleiner als ein Pixel ist!

Durch zwei unterschiedliche Bitmapping-Strategien wird die Verbesserung durch die Grauwert- oder Farbwert-Anpassung aufgezeigt:

### Bitmapping-Strategie mit reinen Schwarz-/Weiß-Pixeln

- Der Innenbereich der Kontur wird mit Pixeln gefüllt.
- Außenkonturen (Masse innenliegend) werden mit weißen Pixeln gefüllt.
- Innenkonturen (Hohlraum innenliegend) werden mit schwarzen Pixeln gefüllt.
- Pixel berühren nur dann die Konturlinie, wenn das Pixel zu mindestens 50% durch den Innenbereich überdeckt wird.

Die so generierte Bitmap **(****Fig. 4****)** zeigt deutlich fehlende Strukturen der Größe 200 µm im Durchmesser.
Der Grund ist, dass bei diesen in der Bitmap nicht dargestellten Strukturen in Abhängigkeit von ihrer Position im Raster kein Pixel mehr als 50% überdeckt wird:

### Abmaße:

| ***Original-Durchmesser*** | ***Bitmap-Darstellung "Bohrung"*** | | ***Bitmap-Darstellung "Zylinder"*** | |
|---|---|---|---|---|
| 200 µm | 1 Pixel | 248 µm | 1 Pixel | 248 µm |
| 500 µm | 2 Pixel | 496 µm | 2 Pixel | 496 µm |
| 1000 µm | 4 Pixel | 992 µm | 4 Pixel | 992 µm |

### Bitmapping-Strategie mit Pixel-genauer Grauwertanpassung:

- Der Innenbereich der Kontur wird mit Pixeln gefüllt.
- Außenkonturen (Masse innenliegend) werden mit "hellen" Pixeln gefüllt.
- Innenkonturen (Hohlraum innenliegend) werden mit "dunklen" Pixeln gefüllt.
- Die Helligkeit bzw. der Grauwert des Pixels ist abhängig von dem Grad der Überlappung durch den Innenbereich.

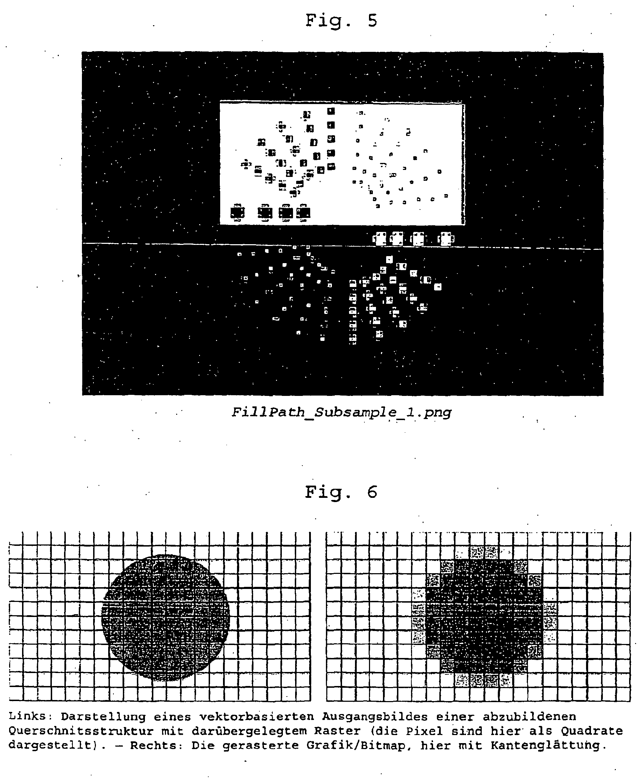

In der so generierten Bitmap **(****Fig. 5****)** werden alle Strukturen / Geometrien sichtbar. Die 200 µm Zylinder sind zu dunkel und die 200 µm Bohrungen sind zu hell. Der Grund dafür ist, dass, - in Abhängigkeit von der Position der Konturen im Pixel-Raster - kein Pixel zu 100% überlappt wird und somit kein Pixel 100% weiß (bei Außenkonturen) oder 100% schwarz (bei Innenkonturen) dargestellt wird:

### Abmaße:

| ***Original-Durchmesser*** | ***Bitmap-Darstellung "Bohrung"*** | | ***Bitmap-Darstellung "Zylinder"*** | |
|---|---|---|---|---|
| 200 µm | ∼1 Pixel | ∼248 µm | ∼1 Pixel | ∼248 µm |
| 500 µm | -2 Pixel | ∼496 µm | -2 Pixel | -496 µm |
| 1000 µm | ∼4 Pixel | ∼992 µm | ∼4 Pixel | ∼992 µm |

### Glättung der Aussen- und Innenkonturen der zu belichtenden Strukturen

Hier wird sich der in der digitalen Bildverarbeitung bereits bekannte Antialiasing-Effekt zunutze gemacht.

Ein bekanntes Problem der Rasterung ist der Alias-Effekt. Steht für die zu erzeugende Rastergrafik eine Grauwerttiefe von mehr als 1 Bit zur Verfügung, so kann dieser Effekt mittels "Kantenglättung" (Antialiasing) vermindert werden. Dazu stehen verschiedene SW-Filtermethoden zur Verfügung.

Beim Antialiasing der Bitmapausgabe wird der so genannte Treppeneffekt - eine Auswirkung vom Aliasing - beseitigt, der bei der Rasterung einer Vektorgrafik (hier die zu belichtenden Querschnittsstruktur) entsteht (**Fig. 6**).

Beim Zeichnen einer Linie können nur horizontale und vertikale Linien problemlos gezeichnet werden, deren Strichstärke ein Vielfaches des Pixelabstands ist und deren Anfangs- und Endpunkt auf einem Pixel liegt. Ist eine Linie etwas schräg, so entstehen zwangsläufig Treppenstufen. Das gleiche widerfährt auch allen runden/freien Formen. Je gröber die Auflösung ist, desto deutlicher wird der Effekt.

Beim Antialiasing von Vektorgrafiken berücksichtigt man, welche Pixel von der Grafik wie stark überschnitten werden und gibt ihnen einen entsprechend gewichteten Grauwert. Dabei werden die Pixel üblicherweise als Quadrate betrachtet. Je mehr von der Pixelfläche durch die Grafik abgedeckt wird, desto heller wird der Grauwert des Pixels eingestellt. Zur Umsetzung werden spezielle Software-Filter eingesetzt.

Durch dieses Verfahren wird letztendlich auch das Aushärteverhalten des Materials entsprechende beeinflusst und so eine höhere Genauigkeit in dem endgültigen Bauteil erzielt.

Die Abbildungs-Ungenauigkeit der Projektionsoptik und des Photopolymers können noch zusätzlich eine Tiefpaßfilter-Funktion ausüben, was einerseits zu einem weiteren Glättungseffekt der Bauteiloberfläche aber andererseits auch zu einem ungenaueren Bauteil, bzw. zu Detailverlusten führen kann.

### Kontrolle der Durchhärtungstiefe mittels Graustufensteuerung in Abhängigkeit der abzubildenden Querschnittsflächenstruktur. / Bauteilgeometrie

### Durchhärtungstiefe bei großflächigen versus filigranen Querschnittsstrukturen

Bei großflächigeren Strukturen steht mehr Lichtleistung pro Fläche zur Verfügung als bei filigranen Strukturen; dieses Phänomen führt zu unterschiedlichen Aushärtung in xy-Ausdehnung (über die Kontur hinaus) und z-Ausdehnung (Tiefe).

Wird z.B. eine 10 mm x 10 mm große Fläche einmalig belichtet, so härtet sie z.B. 130 µm dick aus; eine Struktur von 2 mm x 10 mm härtet bei der selben Belichtungszeit dagegen nur 100 µm aus. Wird das Bauteil nun z.B. in 100 µm Schichten oder einer entsprechenden Voxel-Matrix gebaut, so kann es passieren, dass in dem filigranen Bereich die generierten verfestigten Bereiche keine ausreichende chemische Verbindung durch Überbelichtung (130 µm Tiefenhärtung zu 30% in die vorhergehende Schicht hinein) miteinander eingehen, die Schichten in diesem Bereich separiert werden und das Bauteil defekt ist. Dieses Phänomen ist besonders kritisch bei filigranen Stützstrukturen.

Durch spezielle Algorithmen werden in dem Querschnittsbild Strukturen unterschiedlicher Flächenausdehnung identifiziert und mit entsprechenden Grauwerten pixelgenau belegt, um eine gleichmäßige Durchhärte-Tiefe (Z) und -Ausdehnung (XY) über die gesamte zu belichtende Flächenstruktur zu erhalten (größere Flächenstrukturen werden dabei entsprechend ihrer Ausdehnung abgedunkelt).

### Höhere Grünlingshärte bei massiven Strukturen / höheren Materialansammlungen innerhalb eines Bauteils

Bei manchen Bauteilen ergeben sich Volumenbereiche mit einer Anhäufung von Material, deren Wandstärke zum einen die maximal mögliche Durchhärtetiefe des Materials bei der Nachhärtung überschreitet, oder die sich an einer Position innerhalb des Bauteils befinden, die im Nachhärteprozess nicht oder nur eingeschränkt von der Lichtenergie erreicht werden.

Solche Volumenbereiche können schon während des Generierungsprozesses eine höhere Grünlingshärte erreichen, indem sie gezielt überbelichtet werden. Dies kann durch Ein- ober Mehrfach-Belichtung einzelner oder mehrerer Schichten erfolgen, oder es erfolgt durch entsprechende Grauwert- oder Farbwertbelegung nachfolgender Schichten und insbesondere im Rahmen einer Voxel-Matrix, wobei im letzteren Fall die Durhärtetiefe in Z ein Vielfaches der normalen Durchhärtetiefe beträgt.

Für alle oben beschriebenen Anwendungen kann die Bitmap-Maske / Belichtungsmaske Schwarz/Weiß-, Grauwert- und/oder Farbinformationen enthalten, durch die die Belichtungsenergie gesteuert wird. Die einzeln beschriebenen Ausführungsformen und Beispiele können beliebig miteinander kombiniert werden.

## Patentansprüche

1. Vorrichtung zur Herstellung eines dreidimensionalen Objektes (3) durch Verfestigen eines, unter Einwirkung von elektromagnetischer Strahlung verfestigbaren Materials (4) mittels Energieeintrag über eine bildgebende Einheit, die eine bestimmte Anzahl diskreter bildgebender Elemente oder Pixel aufweist,
**dadurch gekennzeichnet, dass** die Vorrichtung eine Computereinheit, einen IC und/oder eine Softwareimplementierung jeweils mit der Fähigkeit einschließt, den Energieeintrag jedes einzelnen bildgebenden Elements oder Pixels über einen bestimmten Grauwert und/oder Farbwert selektiv einzustellen und/oder zu steuern,
wobei der Energieeintrag jedes einzelnen bildgebenden Elements oder Pixels über einen bestimmten Grauwert und/oder Farbwert gesteuert wird in Abhängigkeit von:
der Größe der Fläche eines Querschnittsbildes vom herzustellenden dreidimensionalen Objekt, wobei größere Flächenstrukturen entsprechend ihrer Ausdehnung mit entsprechenden Grauwerten und/oder Farbwerten abgedunkelt werden.

2. Vorrichtung gemäß Anspruch 1, wobei die bildgebende Einheit eine gerasterte bildgebende Einheit ist, die eine bestimmte Anzahl diskreter, als Punkt, als Zeile oder als Matrix angeordneter bildgebender Elemente oder Pixel aufweist, wobei die bildgebende Einheit ein auf eine bestimmte Querschnittsfläche des dreidimensionalen Objektes bezogenes Bild aus den Pixeln zusammensetzt und so eine gerasterte Maske oder Bitmap bildet.

3. Vorrichtung nach Anspruch 1 oder 2, **dadurch gekennzeichnet, daß** die Bitmap auf der Basis einer gerasterten Graphik oder Vektorgraphik gebildet ist.

4. Vorrichtung nach Anspruch 1 oder 2, **dadurch gekennzeichnet, daß** der Energieeintrag jedes einzelnen bildgebenden Elements oder Pixels so gesteuert wird, daß je mehr von der Pixelfläche durch die Grafik abgedeckt wird, desto heller der Grauwert des Pixels eingestellt wird.

5. Vorrichtung nach einem der Ansprüche 1 bis 4,
**dadurch gekennzeichnet, dass** die bildgebende Einheit bzw. die Computereinheit, der IC und/oder die Softwareimplementierung Informationen bezüglich Grauwert und/oder und Farbwert in dem gerasterten Bild oder Bitmap pro Bildpunkt oder Pixel gespeichert enthält.

6. Vorrichtung nach einem der Ansprüche 1 bis 4, **dadurch gekennzeichnet, dass** Informationen bezüglich Grauwert und/oder Farbwert pro Bildpunkt oder Pixel online für jedes gerasterte Bild oder Bitmap aktuell berechnet sind.

7. Vorrichtung nach einem der vorangehenden Ansprüche, **dadurch gekennzeichnet, dass** die bildgebende Einheit in einer Projektionseinheit (1) eingeschlossen ist.

8. Vorrichtung nach einem der Ansprüche 1 bis 7, **dadurch gekennzeichnet, dass** die bildgebende Einheit vom Typ eines Spatial Light Modulator ist, insbesondere dass es sich bei der bildgebenden Einheit um einen emittierenden Punkt, eine emittierende Zeile oder eine emmitierende Matrix, umfassend Light-Valves in MEMS-Technologie, handelt.

9. Vorrichtung nach einem der Ansprüche 1 bis 7, **dadurch gekennzeichnet, dass** es sich bei der bildgebenden Einheit um einen emittierenden Punkt, eine emittierende Zeile oder eine emittierende Matrix, mit jeweils eingeschlossenen LED's, handelt.

10. Verfahren zur Herstellung eines dreidimensionalen Objektes (3) durch Keine Aufzählungen oder Nummerierungen Verfestigen eines, unter Einwirkung von elektromagnetischer Strahlung verfestigbaren Materials (4) mittels Energieeintrag über eine bildgebende Einheit, die eine bestimmte Anzahl diskreter bildgebender Elemente oder Pixel aufweist,
**dadurch gekennzeichnet, dass** die Lichtleistung zur Verfestigung des Materials selektiv über einen definierten Grauwert und/oder Farbwert gesteuert wird,
wobei der Energieeintrag jedes einzelnen bildgebenden Elements oder Pixels über einen bestimmten Grauwert und/oder Farbwert gesteuert wird in Abhängigkeit von:
der Größe der Fläche eines Querschnittsbildes vom herzustellenden dreidimensionalen Objekt, wobei größere Flächenstrukturen entsprechend ihrer Ausdehnung abgedunkelt werden.

11. Verfahren nach Anspruch 10, **dadurch gekennzeichnet, dass** zur Verfestigung des Materials das Bild mittels einer Projektionseinheit (1) in die Bauebene (7) projiziert wird.

12. Verfahren nach Anspruch 10, **dadurch gekennzeichnet, daß** die Bitmap auf der Basis einer gerasterten Graphik oder Vektorgraphik gebildet wird.

13. Verfahren nach Anspruch 10, **dadurch gekennzeichnet, daß** der Energieeintrag Keine Aufzählungen oder Nummerierungen jedes einzelnen bildgebenden Elements oder Pixels so gesteuert wird, daß je mehr von der Pixelfläche durch die Grafik abgedeckt wird, desto heller der Grauwert des Pixels eingestellt wird.

## Claims

1. A device for producing a three-dimensional object (3) by solidifying a material (4) solidifiable under the action of electromagnetic radiation through energy input via an imaging unit which comprises a certain number of discrete imaging elements or pixels, **characterized in that** the device comprises a computer unit, an IC and/or a software implementation, respectively with the ability of adjusting and/or controlling the energy input via a specific gray value and/or color value,
wherein the energy input of each individual imaging element or pixel is controlled via a specific gray value and/or color value depending on:
the size of the area of a cross-sectional image of the three-dimensional object, wherein larger structural areas are darkened by corresponding grey values and/or color values according to their expansion.

2. The device according to claim 1 wherein the imaging unit is a raster imaging unit which comprises a certain number of discrete imaging elements or pixels arranged as dot, line or matrix, wherein the imaging unit composes an image related to a specific cross-sectional area of the three-dimensional object from the pixels and thus forms a raster mask or bitmap.

3. The device according to claim 1 or 2, wherein the bitmap is formed on the basis of a raster graphic or a vector graphic.

4. The device according to claim 1 or 2, **characterized in that** the energy input of each individual imaging element or pixel is controlled such that, the more of the pixel area is covered by the graphic, the lighter the gray value of the pixel is adjusted.

5. The device according to any one of claims 1 to 4, wherein the imaging unit or, respectively, the computer unit, the IC and/or the software implementation contains information with respect to gray value and/or color value stored in the raster image or bitmap per image element or pixel.

6. The device according to any one of claims 1 to 4, wherein information with respect to gray value and/or color value per image element or pixel is currently calculated online for each raster image or bitmap.

7. The device according to one of the preceding claims, wherein the imaging unit is included in a projection unit (1).

8. The device according to one of claims 1 to 7, wherein the imaging unit is of the type of a Spatial Light Modulator, particularly wherein the imaging unit is an emitting dot, an emitting line or an emitting matrix, comprising light valves in MEMS technology.

9. The device according to one of claims 1 to 7, wherein the imaging unit is an emitting dot, an emitting line or an emitting matrix, respectively comprising LEDs.

10. A method for producing a three-dimensional object (3) by solidifying a material (4) solidifiable under the action of electromagnetic radiation through energy input via an imaging unit which comprises a certain number of discrete imaging elements or pixels, **characterized in that** the light output for solidifying the material is selectively controlled by a defined gray value and/or color value,
wherein the energy input of each individual imaging element or pixel is controlled via a specific gray value and/or color value depending on:
the size of the area of a cross-sectional image of the three-dimensional object, wherein larger structural areas are darkened according to their expansion.

11. The method according to claim 10, wherein for the solidification of the material the image is projected by means of a projection unit (1) into the building plane (7).

12. The method according to claim 10, wherein the bitmap is formed on the basis of a raster graphic or a vector graphic.

13. The method according to claim 10, **characterized in that** the energy input of each individual imaging element or pixel is controlled such that, the more of the pixel area is covered by the graphic, the lighter the gray value of the pixel is adjusted.

## Revendications

1. Dispositif pour la fabrication d'un objet tridimensionnel (3) par la consolidation d'un matériau (4) susceptible d'être consolidé sous l'action d'un rayonnement électromagnétique au moyen d'une introduction d'énergie via une unité de création d'images, lequel dispositif présente un nombre déterminé d'éléments créateurs d'images discrets ou des pixels,
**caractérisé en ce que** le dispositif comprend un ordinateur, un circuit intégré et/ou une implémentation de logiciel, à chaque fois avec la possibilité de régler et/ou de commander sélectivement l'introduction d'énergie de chacun des éléments créateurs d'images discrets ou des pixels via un niveau de gris et/ou un niveau de couleur déterminés,
sachant que l'introduction d'énergie de chacun des éléments créateurs d'images discrets ou des pixels est commandée via un niveau de gris et/ou un niveau de couleur déterminés en fonction de :
la dimension de la surface d'une image de section transversale par rapport à l'objet tridimensionnel à fabriquer, des structures de surfaces plus importantes étant assombries selon leur extension avec des niveaux de gris et/ou des niveaux de couleur correspondants.

2. Dispositif selon la revendication 1, sachant que l'unité de création d'images est une unité de création d'images scannée, qui présente un nombre déterminé d'éléments créateurs d'images discrets ou de pixels disposés en tant que point, en tant que ligne ou en tant que matrice, sachant que l'unité de création d'images compose une image se rapportant à une surface de section transversale déterminée de l'objet tridimensionnel à partir des pixels et forme ainsi un masque scanné ou un topogramme binaire.

3. Dispositif selon la revendication 1 ou 2, **caractérisé en ce que** le topogramme binaire est formé sur la base d'un graphique scanné ou d'un graphique vectoriel.

4. Dispositif selon la revendication 1 ou 2, **caractérisé en ce que** l'introduction d'énergie de chacun des éléments créateurs d'images discrets ou des pixels est commandée de telle sorte que plus le nombre de surfaces de pixels recouvertes par le graphique est important, plus le niveau du pixel est clair après réglage.

5. Dispositif selon une des revendications 1 à 4, **caractérisé en ce que** l'unité de création d'images, respectivement l'ordinateur, le circuit intégré et/ou l'implémentation de logiciel stockent des informations concernant le niveau de gris et/ou le niveau de couleur dans l'image scannée ou le topogramme binaire par point d'image ou par pixel.

6. Dispositif selon une des revendications 1 à 4, **caractérisé en ce que** les informations concernant le niveau de gris et/ou le niveau de couleur par point d'image ou par pixel peuvent être calculées couramment en ligne pour chaque image scannée ou topogramme binaire.

7. Dispositif selon l'une quelconque des revendications précédentes, **caractérisé en ce que** l'unité de création d'images est incluse dans une unité de projection (1).

8. Dispositif selon une des revendications 1 à 7, **caractérisé en ce que** l'unité de création d'images est du type d'un modulateur de lumière spatial (Spatial Light Modulator), en particulier **en ce que** l'unité de création d'images est un point émetteur, une ligne émettrice ou une matrice émettrice comprenant des valves de lumière dans une technologie MEMS.

9. Dispositif selon l'une quelconque des revendications 1 à 7, **caractérisé en ce que** l'unité de création d'images est un point émetteur, une ligne émettrice ou une matrice émettrice avec les LED respectives incluses.

10. Procédé pour la fabrication d'un objet tridimensionnel (3) par la consolidation d'un matériau (4) susceptible d'être consolidé sous l'action d'un rayonnement électromagnétique au moyen d'une introduction d'énergie via une unité de création d'images présentant un nombre déterminé d'éléments créateurs d'images discrets ou des pixels,
**caractérisé en ce que** le rendement lumineux destiné à la consolidation du matériau est commandé sélectivement via un niveau de gris et/ou un niveau de couleur définis,
sachant que l'introduction d'énergie de chacun des éléments créateurs d'images discrets ou des pixels est commandée via un niveau de gris et/ou un niveau de couleur déterminés en fonction de :
la dimension de la surface d'une image de section transversale par rapport à l'objet tridimensionnel à fabriquer, des structures de surfaces plus importantes étant assombries selon leur extension.

11. Procédé selon la revendication 10, **caractérisé en ce que** l'image est projetée dans le plan de construction (7) au moyen d'une unité de projection (1) pour la consolidation du matériau.

12. Dispositif selon la revendication 10, **caractérisé en ce que** le topogramme binaire est formé sur la base d'un graphique scanné ou d'un graphique vectoriel.

13. Dispositif selon la revendication 10, **caractérisé en ce que** pour (i) l'introduction d'énergie de chacun des éléments créateurs d'images discrets ou des pixels est commandée de telle sorte que plus le nombre de surfaces de pixels recouvertes par le graphique est important, plus le niveau du pixel est clair après réglage.
